# EUROPEAN PATENT APPLICATION

(11) **EP 1 168 540 A2**
(43) Date of publication of application: **02.01.2002**
(21) Application number: 01113686.8
(22) Date of filing: 20.06.2001
(51) Int. Cl.: H01S 5/227

(54) **Semiconductor laser device**

(30) Priority: 20.06.2000 JP 2000185109; 26.12.2000 US 750504
(71) Applicant: THE FURUKAWA ELECTRIC CO., LTD., Tokyo (JP)
(72) Inventor: Yoshida, Junji, Chiyoda-ku, Tokyo (JP); Tsukiji, Naoki, Chiyoda-ku, Tokyo (JP)
(74) Representative: Modiano, Guido, Dr.-Ing.

(57) **Abstract**

In a III - V semiconductor laser diode, a spacer layer is used between an n-doped cladding layer and an undoped optical confinement layer to mitigate crystal defects that would otherwise be formed at the interface between the layers due to the memory effect associated with doping the cladding layer. The spacer layer is formed of compatible III - V semiconductor compounds and may be either a single layer or a plurality of sublayers. The spacer layer of the present invention also has application to other semiconductor devices where the memory effect causes crystal defects at the interface between two differently doped layers.

## Description

### Field of the Invention

The present invention is related to semiconductor devices and has particular application to separate confinement heterostructure (SCH) laser diodes formed from III - V semiconductor compounds.

### Background of the Invention

The explosive growth of the Internet and other communications systems has created a strong demand for optical systems to meet the need for capacity to transport data. The laser diode is a key component of many fiber-optic systems, and in recent years a great deal of attention has been devoted to developing and improving reliable high-power pumping lasers for use in the optical fiber amplifiers (OFA's) employed in such systems.

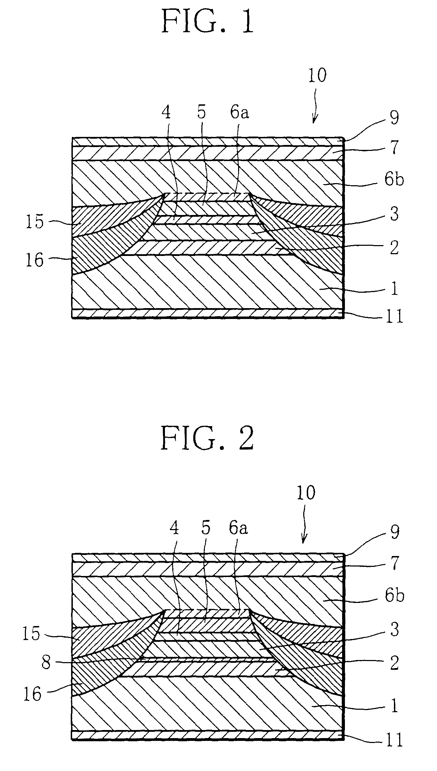

A preferred type of semiconductor laser is the separate confinement heterostructure (SCH), where the SCH is comprised of optical confinement layers and active layer, or more preferably, the graded-index, separate confinement structure (GRIN-SCH) device fabricated from III - V semiconductor compounds A quantum well structure may be used to form an active, light-emitting layer in such a device because of its ability to lase at a relatively small injection current and its high differential quantum efficiency. A typical prior art GRIN-SCH semiconductor laser device 10 is depicted in FIG. 1. A substrate 1 is provided and an n-type lower cladding layer 2 is formed on the substrate. Next an undoped lower optical confinement layer 3 is formed on the lower cladding layer, and a light emitting active layer 4 is formed on the optical confinement layer. As is known in the art, active layer 4 may have a quantum well structure comprising a plurality of individual sublayers. On top of active layer 4 are undoped upper optical confinement layer 5, and a p-doped upper cladding layer 6a. As is known in the art, the foregoing structure is etched to give the device a desired shape and the areas that have been etched away are filled with current blocking layers 15 and 16. A second p-doped upper cladding layer 6b is then formed over the resulting structure and upper and lower electrodes 9 and 11 are formed on the top and bottom surfaces. One or more protective films (not shown) may also be formed on the top and bottom surfaces of the device.

The layers in the prior art device of FIG. 1 may be made of various types of III - V semiconductor compounds such as InP, GaAs, GaInAsP, AIGaInAs or AIGaAsP which are appropriately doped. Typical n-type substances include selenium (Se) and sulfer (S) as dopants, and typically zinc (Zn) is used as the p-type dopant.

Various techniques for forming the layers of the semiconductor device are known in the art, including metal organic chemical vapor deposition (MOCVD), molecular beam epitaxy (MBE), gas source MBE, or chemical beam epitaxy (CBE). Of these, MOCVD is the most commonly used. However, when using MOCVD a "memory effect" relating to the incorporation of dopant has been reported. This is particularly a problem when using H₂Se as an n-dopant gas. After the supply of H₂Se is stopped, the "memory effect" causes auto doping of Se into the successively grown layer . In the prior art device of FIG. 1, the memory effect arises in connection with the formation of lower cladding layer 2. In the process of developing higher powered laser diodes, the inventors have discovered a new degradation source during reliability testing which could be related to the memory effect. The degradation was more frequently observed in cases when H₂Se was used as a dopant gas for the lower n-cladding layer in MOCVD growth. The observed degradation appears to be due to the existence of crystal defects at the interface between the lower cladding and lower optical confinement layers caused by the memory effect associated with the cessation of Se doping.

As described herein, the inventors have observed that when the undoped optical confinement layer 3 is grown over the n-doped lower cladding layer, crystal defects are created. Such crystal defects, particularly defects which propagate into active layer 4 during the operation of the laser, can adversely affect the performance of the laser device 10. Crystal defects create non- radiative recombination centers which lower device efficiency and reduce light output. Long term device reliability may also suffer as lattice defects are propagated from the surface of lower cladding layer 2 through other layers in the device. Accordingly, there is a need for an improved laser device which solves the foregoing problems.

Further, there is a need for a semiconductor laser structure which avoids the creation of lattice defects due to the memory effect which impair the efficiency of the device.

Moreover, there is a need for a technique and structure to mitigate the problems associated with the memory effect when incorporating doping material into a III - V semiconductor layer using MOCVD which is formed adjacent to an undoped layer.

Further, there is a need for a technique and structure for mitigating the effects of lattice defects when depositing an undoped semiconductor layer over an n-InP layer due to the formation of In₂Se₃ on the surface of the InP layer.

Additionally, there is a need for a structure in a semiconductor laser device which prevents the propagation of lattice defects into the active layer of the device.

### Summary of the Invention

The present invention is generally directed to semiconductor devices, particularly semiconductor lasers formed from III - V semiconductor compounds, which include a spacer layer between a doped layer and an undoped layer to mitigate the adverse effects which may otherwise occur, such as lattice defects, due to the memory effect. In one embodiment, the present invention comprises a semiconductor laser device which has a doped semiconductor cladding layer, an optical confinement layer and an undoped spacer layer between the cladding layer and the optical confinement layer. The invention is particularly useful when the cladding layer is an n-doped layer using selenium as the dopant and the cladding layer is deposited using MOCVD. Preferably the undoped spacer layer has a thickness of about 5 nm or more and is formed from III - V semiconductors having bandgap wavelength in the range of 0.92 to 1.1 µm. The spacer layer may be formed from InP, from a single layer of GaInAsP, from two or more sublayers of GaInAsP having differing compositions, or from a strain compensated superlattice structure. The optical confinement layer is preferably adjacent to a active layer which is preferably a quantum well structure.

In another aspect, the present invention encompasses a method of making a semiconductor laser comprising the steps of forming an n-doped semiconductor lower cladding layer, forming an undoped semiconductor spacer layer over said lower cladding layer, forming a optical confinement layer over said undoped spacer layer, and forming an active layer over said optical confinement layer. This method is particularly useful in avoiding the adverse consequences of the "memory effect" which occurs when forming n-doped semiconductor materials using MOCVD.

### Brief Description of the Drawings

FIG. 1 is a cross-sectional view of an exemplary prior art semiconductor GRIN-SCH laser diode.
FIG. 2 is a cross-sectional view of a semiconductor GRIN-SCH laser diode of the present invention.
FIG. 3 is a graph showing the percent ratio of devices having observable defects at the interface between the spacer layer of the present invention and the overlying optical confinement layer as a function of the thickness of the spacer layer.

### Detailed Description

As depicted in FIG. 1, an exemplary prior art graded-index, separate confinement heterostructure (GRIN-SCH) semiconductor laser diode 10 comprises an n-doped lower cladding layer 2 formed on top of a base substrate 1, which also may be n-doped. Substrate 1 and lower cladding layer 2 may be made of InP. A lower optical confinement layer 3 is then formed over the cladding layer. An active layer 4, such as a quantum well structure, an upper optical confinement layer 5 and a p-doped upper cladding sublayer 6a are formed over lower optical confinement layer 3 in that order. The resulting structure is then etched using known techniques and current blocking layers 15 and 16 are formed around the etched mesa. Upper cladding sublayer 6b is then formed over the resulting structure. Upper cladding layers 6a and 6b may also be made from InP. A contact layer 7 may be formed from III-V semiconductor materials. Finally, electrodes 9 and 11 are formed on the upper and lower surfaces of the device to allow current injection into the device. Electrodes 9 and 11 may be formed from ohmic metals, as is known in the art. Protective films (not shown) may also be added to the exemplary prior art structure of FIG. 1.

The various semiconductor layers of the device of FIG. 1 may be formed from III - V semiconductor compounds by MOCVD. However, as discussed in detail above, it is difficult to avoid the problems associated with memory effect in the conventional layer structure and this is a particular problem when using H₂Se as an n- dopant gas material. Accordingly, with the increasingly stringent demands for device power, device efficiency, device reliability, the prior art device design of FIG. 1 requires improvement to overcome the problem of defect generation associated with the memory effect.

Turning to FIG. 2, an improved GRIN-SCH semiconductor laser device 20 of the present invention is shown. In FIG. 2 like numbers are used to designate the features of the invention which are the same as depicted in FIG. 1. Thus, the device of FIG. 2 comprises an n-doped substrate 1, an n-doped lower cladding layer 2, a lower optical confinement layer 3, and active layer 4, an upper optical confinement layer 5, p-doped upper cladding layers 6a and 6b, a p-doped contact layer 7, current blocking layers 15 and 16 and electrodes 9 and 11. Substrate 1 is preferably InP, active layer 4 is preferably a GaInAsP quantum well structure, and cladding layers 2, 6a and 6b are preferably appropriately doped InP.

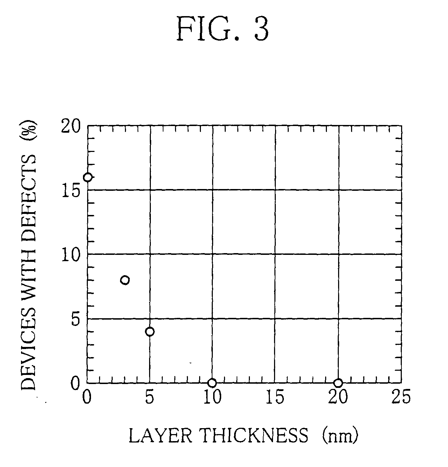

In order to overcome the problems associated with the generation of defects at the interface between lower cladding layer 2 and lower optical confinement layer 3, an undoped spacer layer 8 is formed between n-doped lower cladding layer 2 and lower optical confinement layer 3. As described in detail below in connection with Table 1 and FIG. 3, it has been determined that the use of undoped spacer layer 8 mitigates the problem of defect generation. Preferably, spacer layer 8 is about 5 nm or more in thickness. As described below, at this thickness lattice defects due to the memory effect are substantially eliminated, although it appears that layers which are thinner may also be useful.

Spacer layer 8 is preferably formed from an undoped III - V semiconductor compound which is compatible with the other structures in the overall laser device. Particularly useful materials include InP and GaInAsP, since these materials are typically used to form the other layers in the device. Preferably, the selected material has a bandgap wavelength in the range of 0.92-1.1 µm. When using GaInAsP as the material for spacer layer 8, the layer may be deposited as a uniform single layer, as two or more sublayers with different compositions, such as in a super lattice structure, or as a layer having a graded composition (*i.e*., a composition slope layer).

Lower and upper optical confinements layer 3 and 5, overlying spacer layer 8 and active layer 4, respectively, are preferably made of undoped GaInAsP material system.

Active layer 4 is preferably a multi-quantum well structure also made from GaAsInP and having 1 to 5 wells, with the layers having a compressive strain in the range of about 0.8 - 1.5%.

### Example

The following experiments were performed. In order to confirm the memory effect of Se on defects at the interface between the n-doped lower cladding layer and the undoped optical confinement layer, sample devices with various thickness of an undoped spacer layer (InP) between these two layers were fabricated.

A plurality of laser devices were constructed as follows. An n-doped InP substrate 1 was provided and an n-InP lower cladding layer 2 having a thickness of about 1 µm was formed using MOCVD. Lower cladding layer 2 was selenium-doped in a concentration of 1 x 10¹⁸ atoms per cm³.

Next, a spacer layer 8 of undoped InP was formed by MOCVD on top of lower cladding layer 2. In order to evaluate the effectiveness of the present invention, devices were prepared with spacer layers having a thickness of 3 nm, 5 nm, 10 nm, 20 nm and 500 nm, respectively. In order to increase the abruptness of the interface between the lower cladding layer and the spacer layer, a twenty second interruption in the MOCVD growth process was used between steps. In order to compare the present invention with a structure of the type known in the prior art, "control" devices without any spacer layer were fabricated using the same processing steps and structure. In the following discussion it is useful to consider these control devices as having a spacer layer of zero thickness, as the context requires.

Next a lower optical confinement layer 3 of GaInAsP thickness 40nm was formed over the spacer layer by MOCVD. Lower optical confinement layer 3 consisted of two sublayers of GaInAsP having bandgap wavelength of 1.05 µm and 1.15 µm respectively.

An active layer 4 comprising four 3 nm quantum wells of GaAsInP having a 1% compressive strain was then formed over lower optical confinement layer 3 by MOCVD. A 40 nm thick upper optical confinement layer 5 consisting of undoped GaInAsP layers having bandgap wavelength of 1.15 µm and 1.05 µm was then formed on top of active layer 4 using MOCVD, and a 0.5 µm p-type InP cladding layer 6a was formed over upper optical confinement layer 5, also by MOCVD. The InP upper cladding layer 6a was doped with zinc at a concentration of 7 x 10¹⁷ atoms per cm³.

The resulting structure was then subjected to photolithography and wet etching to form a mesa as depicted in FIG. 2. Current blocking layers 15 and 16 of p-type InP and n-type InP were then regrown in the area around the mesa, as is known in the art, using MOCVD. An additional upper cladding layer 6b of p-doped InP having a thickness of 3.0 µm was then formed over the structure. This additional upper cladding layer 6b was doped with zinc at the same concentration as the first upper cladding layer 6a. Next, a 0.5 µm thick contact layer 7 of p-type GaInAsP was formed on top of the structure using MOCVD.

A p-type electrode 11 made of Ti/Pt/Au was formed on top of cap layer 7 and a n-type electrode 9 of Au-Ge/Ni/Au was formed on the bottom surface of InP substrate 1 after it had been polished. The entire structure 10 was then cleaved to form a device having a cavity length of 1000 µm. An antireflection coating (not shown) having a 5% reflectance was formed on the front (light emitting) facet of the device, and a high reflection coating (not shown) having a 98% reflectance was formed on the back facet. Twenty five lasers of each spacer layer thickness were fabricated in this manner and were examined.

Each of the devices were viewed in cross section using a transmission electron microscope to check for the existence of crystal defects at the interface between spacer layer 8 of the present invention and lower optical confinement layer 3. Twenty-five devices which were fabricated without a spacer layer 8 between lower cladding layer 2 and optical confinement layer 3 were also examined in this manner. Table 1, below, summarizes the results of this study. The results are also shown in FIG. 3.

**Table 1**

| Thickness of Spacer Layer (nm) | Number of Devices Having An Observable Defect (Total count = 25) | Percentage of Devices Having An Observable Defect |
|---|---|---|
| 0 | 4 | 16 |
| 3 | 2 | 8 |
| 5 | 1 | 4 |
| 10 | 0 | 0 |
| 20 | 0 | 0 |
| 500 | 0 | 0 |

As can be seen from Table 1 and FIG. 3, there is a drastic decrease in the number of defects in the crystal interface as the thickness of the spacer layer goes from 0 to 10 nm. At 10 nm the number of defects is not observed.

Fifteen of each of the devices were further examined to study the long term reliability of the devices in operation. In this experiment, the drive current of each device was set to provide a light output from each device of 80% of the maximum light output, and the devices were operated at 60° C. After 10,000 hours of operation the drive current was measured to determine how much increased current was necessary to maintain the light output at 80% of maximum. For the control devices constructed without a spacer layer between the lower cladding layer and the lower optical confinement layer, one third of the devices tested (*i.e.*, five devices) required a current increase of approximately 8% to maintain light output. For the devices having a spacer layer thickness of 3 nm and 5 nm there were three and one devices, respectively, which required a current increase of 5%. Finally, for the remaining embodiments, (10 nm, 20 nm and 500 nm) all of the devices tested had only a 2% increase in current requirements after 10,000 hours of operation. These experiments demonstrate that the incorporation of an undoped spacer layer between the lower cladding layer and the optical confinement layer provides a substantial benefit, and that this benefit is almost fully realized when the spacer layer is about 5 nm thick.

It is believed that the foregoing experimental results can be explained as follows. In the prior art structure, defect nucleation sites are created by the presence of residual selenium (most likely in the form of Se₂In₃) on the surface of the lower n-cladding layer when crystal growth is interrupted. The defect nucleation sites cause crystal defects to form when the GaInAsP optical confinement layer is then deposited. This is consistent with the fact that the frequency of the samples in which the defects were induced was dramatically reduced with the use of a spacer layer of sufficient thickness, since the spacer layer eliminates the residual Se.

While the present invention has been described in connection with a laser constructed from InP and GaInAsP, those skilled in the art will appreciate that the same benefits will be realized when the device is constructed from other III - V semiconductor compounds, including, for example, GaAs and GaInAsP. Likewise, although the preferred embodiment has been described in connection with layers grown by MOCVD, wherein the memory effect may be most pronounced, those skilled in the art will appreciate that the crystal growth methods used for formation of the III - V semiconductor materials of the present invention is not critical and that the benefits of the invention will be realized in connection with devices formed using other crystal growth techniques, such as molecular beam epitaxy (MBE), gas source MBE or CBE. Finally, although the present invention has been described in connection with laser devices, it will be appreciated by those skilled in the art that there are other semiconductor devices with similar layer structure, such as a hetero-bipolar transistors with an n-doped InP collector layer, a p-doped ternary or quaternary base layer and an n-doped AIGaIAs emitter layer, wherein the presence of an n-doping material on the surface of a layer causes undesirable crystal defects. It will be apparent to those skilled in the art that the spacer layer of the present invention will overcome problems which may arise from such defects. Accordingly, it is intended that the scope of the invention be limited only by the appended claims.
Where technical features mentioned in any claim are followed by reference signs; those reference signs have been included for the sole purpose of increasing the intelligibility of the claims and accordingly, such reference signs do not have any limiting effect on the scope of each element identified by way of example by such reference signs.

## Claims

1. A semiconductor laser device, comprising:
a doped semiconductor cladding layer;
a semiconductor optical confinement layer; and
an undoped semiconductor spacer layer positioned between said cladding layer and said optical confinement layer.

2. The laser device of claim 1, wherein said undoped spacer layer has a thickness of more than about 4 nm.

3. The laser device of claim 1 wherein said semiconductor cladding layer is n-doped.

4. The laser device of claim 3 wherein the n-doping material in said cladding layer is selenium.

5. The laser device of claim 1 wherein said undoped spacer layer comprises InP, GaInAsP, or AlGaInAs.

6. The laser device of claim 5 wherein said undoped spacer layer consists of a single layer.

7. The laser device of claim 5 wherein said undoped spacer layer consists of a single layer of GaInAsP having a bandgap wavelength in the range of 0.92 - 1.1 µm.

8. The laser device of claim 5 wherein said undoped spacer layer consists of a graded composition layer of GaInAsP or AlGaInAs having a bandgap wavelength in the range of 0.92 - 1.1 µm.

9. The laser device of claim 5 wherein said undoped spacer layer comprises two sub-layers of GaInAsP or AIGaInAs of differing compositions, each of said two or more sub-layers having a bandgap wavelength in the range of 0.92 - 1.1 µm.

10. The laser device of claim 5 wherein said undoped spacer layer comprises a strain compensated superlattice layer.

11. The semiconductor device of claim 1 wherein said semiconductor layers are formed by MOCVD.

12. A semiconductor laser device, comprising:
a semiconductor substrate;
an n-doped semiconductor lower cladding layer;
a semiconductor lower optical confinement layer;
an undoped semiconductor spacer layer between said lower cladding layer and said lower optical confinement layer;
a semiconductor active layer for generating light;
a semiconductor upper optical confinement layer;
a p-doped semiconductor upper cladding layer; and
electrodes for current injection to said device.

13. The semiconductor laser device of claim 12 wherein said undoped spacer layer has a thickness greater than about 4 nm.

14. The semiconductor laser device of claim 12 wherein all of said semiconductor layers are formed from III - V semiconductor compounds.

15. The semiconductor device of claim 12 wherein said active layer comprises a quantum well structure.

16. The semiconductor device of claim 12 wherein the doping material in said n-doped lower cladding layer is selenium.

17. The semiconductor device of claim 12 wherein said undoped spacer layer has a bandgap wavelength in the range of 0.92 - 1.1 µm.

18. The semiconductor device of claim 12 wherein said spacer layer consists of a layer selected from the group consisting of InP, a single layer of GaInAsP or AlGaInAs, two or more sublayers of GaInAsP or AlGaInAs of differing composition, and a superlattice structure.

19. The semiconductor device of claim 12 wherein said semiconductor layers are formed using MOCVD.

20. A method of making a semiconductor laser device, comprising the steps of:
forming an n-doped semiconductor lower cladding layer on a substrate;
forming an undoped semiconductor spacer layer over said lower cladding layer;
forming a semiconductor optical confinement layer over said spacer layer; and
forming an active, light emitting semiconductor layer over said optical confinement layer.

21. The method of claim 20 wherein each of said semiconductor layers are formed using MOCVD.

22. The method of claim 20 wherein the doping material used in said n-doped lower cladding layer is selenium.

23. The method of claim 20 wherein said undoped spacer layer has a bandgap wavelength in the range of 0.92 - 1.1 µm.

24. The method of claim 20 wherein said lower cladding layer consists of n-doped InP and wherein said lower cladding layer is formed on an InP substrate.

25. The method of claim 20 wherein said undoped spacer layer consists of a single layer of InP.

26. The method of claim 20 wherein said undoped spacer layer consists of a single layer of GaInAsP.

27. The method of claim 20 wherein said undoped spacer layer consists of a two or more sublayers of GaInAsP or AIGaInAs, each of said two layers having a different composition.

28. The method of claim 20 wherein said undoped spacer layer has a thickness greater than about 4 nm.

29. A semiconductor device comprising:
a first n-doped III - V semiconductor layer formed by MOCVD,
an undoped III - V semiconductor spacer layer formed by MOCVD deposited directly on said n-doped layer,
a III - V semiconductor layer formed over said spacer layer, whereby lattice defects caused by said n-doped III - V semiconductor layer are mitigated by said spacer layer.

30. A method of making a III - V semiconductor device, comprising the steps of:
depositing a layer of a III - V semiconductor compound doped with selenium using MOCVD;
depositing a spacer layer of an undoped III - V semiconductor compound directly on said selenium-doped layer using MOCVD;
depositing an active layer comprising one or more III - V semiconductor compounds over said spacer layer.
